Europäisches Patentamt

European Patent Office

Office européen des brevets

(19)

(11) Veröffentlichungsnummer. **0 023 240**

**A1**

(12) **EUROPÄISCHE PATENTANMELDUNG**

(21) Anmeldenummer: 80101060.4

(22) Anmeldetag: 03.03.80

(51) Int. Cl.³: **C 23 C 17/00**
**C 08 J 7/06**

(30) Priorität: 28.07.79 DE 2930784

(43) Veröffentlichungstag der Anmeldung:
04.02.81 Patentblatt 81/5

(84) Benannte Vertragsstaaten:
AT BE CH DE FR GB IT LU NL SE

(71) Anmelder: Licentia Patent-Verwaltungs-GmbH
Theodor-Stern-Kai 1
D-6000 Frankfurt Main 70(DE)

(72) Erfinder: Künzig, Herbert
Scharnhorst Strasse 7
D-8750 Aschaffenburg(DE)

(74) Vertreter: Lertes, Kurt, Dr.
Licentia Patent-Verwaltungs-GmbH Theodor-Stern-Kai
1
D-6000 Frankfurt 70(DE)

(54) **Verfahren zur Aktivierung von Kunststoffoberflächen.**

(57) Bei einem Verfahren zur Aktivierung von Kunststoffoberflächen für eine chemische Bekeimung mit einem Edelmetall, an die sich eine Metallisierung anschließt, werden folgende Verfahrensschritte durchgeführt:
1.1 die Kunststoffoberfläche wird mechanisch aufgerauht,
1.2 der Kunststoff wird in eine Lösung eines Komplexbildners eingetaucht,
1.3 der Kunststoff wird anschließend in eine Lösung eines Edelmetallkomplexsalzes eingetaucht, so daß an der Kunststoffoberfläche ein Austausch der im Verfahrensschritt 1.2 angelagerten Komplexe gegen Edelmetallkomplexe erfolgt,
1.4 die Edelmetallkomplexe werden zu Metallkeimen redu-ziert.

EP 0 023 240 A1

Croydon Printing Company Ltd.

1

Verfahren zur Aktivierung von
Kunststoffoberflächen

Verfahren zur Aktivierung von Kunststoffoberflächen
für eine chemische Bekeimung mit einem Edelmetall,
so daß danach eine Metallisierung vorgenommen werden
kann.

Bei der Metallisierung von ABS-Kunststoffen ist es
üblich, nach der mechanischen Aufrauhung die Oberfläche mittels eines starken Oxidationsmittels, z.B.
heißen $SO_3$ - Dampfes, zu aktivieren, um eine nachfolgende Edelmetallbekeimung durchführen zu können.
Unter ABS-Kunststoffen sind solche aus Acrylnitril-
Butadien-Styrol bzw. modifizierten Plexiglas-Verbindungen zu verstehen. Auf den Edelmetallkeimen werden danach Metalle, z.B. Kupfer, Nickel, Silber, Gold
chemisch abgeschieden. Die vorstehend erläuterten
Maßnahmen sind als SAN-Verfahren bezeichnet worden.

Der Nachteil dieses Verfahrens besteht darin, daß
der $SO_3$- Dampf nicht nur sehr giftig sondern auch
stark korrosiv ist. Dies bedingt einen erheblichen
anlagentechnischen Aufwand, um die Umweltbelastung
in Grenzen zu halten und die Gesundheitsgefährdung
der die Anlagen bedienenden Personen zu verhindern.

2

Der Erfindung liegt die Aufgabe zugrunde, ein nichtoxydatives Verfahren zur Aktivierung von Kunststoffoberflächen zu entwickeln.

Die Aufgabe wird erfindungsgemäß durch folgende Verfahrensschritte gelöst:

1.1 die Kunststoffoberfläche wird mechanisch aufgerauht,

1.2 der Kunststoff wird in eine Lösung eines Komplexbildners eingetaucht,

1.3 der Kunststoff wird anschließend in eine Lösung eines Edelmetallkomplexsalzes eingetaucht, so daß an der Kunststoffoberfläche ein Austausch der im Verfahrensschritt 1.2 angelagerten Komplexe gegen Edelmetallkomplexe erfolgt,

1.4 die Edelmetallkomplexe werden zu Metallkeimen reduziert.

Bei diesem Verfahren werden ausschließlich nicht umweltbelastende Materialien verwendet, die ohne großen apparativen Aufwand zu beherrschen sind. Außerdem sind die eingesetzten Materialien kostengünstig verfügbar, so daß die Aktivierung in besonders wirtschaftlicher Weise ausführbar ist. Bei der Durchführung des Verfahrens entstehen darüber hinaus keine aggressiv gefährlichen Dämpfe.

Die Erfindung wird im folgenden an Hand eines Ausführungsbeispiels näher erläutert, aus dem sich weitere Merkmale sowie Vorteile ergeben.

Bei einer zweckmäßigen Ausführungsform erfolgt die mechanische Aufrauhung nach dem Verfahrensschritt 1.1) mittels Glaskugelstrahlen, bei dem die Glaskugeln einen Durchmesser von etwa 120 bis 250 $\mu$m haben.

Die Glaskugeln werden durch eine Laval-Düse mittels Preßluft auf die Kunststoffoberfläche geschossen. Dabei entsteht eine Mikrorauhigkeit, die die Grundlage für die Benetzbarkeit des Kunststoffs und die Haftfähigkeit der Metallisierung darstellt. Die makroskopisch betrachtete Oberfläche trägt die Struktur eines Hammerschlags. Bei dem Einsatz von Glaskugeln entsteht kein merklicher Materialabtrag, da im wesentlichen die Oberfläche nur deformiert wird.

Bei Verwendung eines Kunststoffs mit Glasfaserverstärkung wird bei einer vorteilhaften Ausführungsform nach der Durchführung der Aufrauhung mit Glaskugeln der Kunststoff mit einem handelsüblichen Conditioner behandelt, um eine Benetzbarkeit der Glasfasern zu erreichen. Wenn die Benetzbarkeit der Glasfasern vorhanden ist, ergibt sich eine nennenswerte Erhöhung der Haftfestigkeit der chemischen Metallisierung. Geeignet ist der Conditioner 1160 der Firm Shipley GmbH.

Vorzugsweise werden bei dem Verfahrensschritt 1.2) als Komplexbildner Äthylendiamintetraessigsäure oder deren Alkalisalze verwendet. Diese Komplexbildner lassen sich bevorzugt alkalisch lösen, wobei die alkalische Lösung die mechanisch aufgerauhte Oberfläche des Kunststoffs in den hydrophilen Oberflächenzustand überführt. Dieser wiederum gestattet die Anlagerung des Komplexbildners.

Vorteilhafterweise setzt man die alkalische Lösung wie folgt an:
Man löst Alkalihydroxid in Wasser, wobei sich die Lösung erwärmt, und setzt den Komplexbildner zu. Der Komplexbildner bietet dabei den Vorteil, daß die verwendeten Gefäße von der Alkalilauge nicht merklich angegriffen werden. Deshalb kann man preiswerte Kunststoffgefäße einsetzen, die der Lösung ohne weiteres widerstehen. Ein geeigneter Komplexbildner ist das Natriumsalz der Äthylendiamintetraessigsäure. Die Konzentration der Komplexbildnerlösung ist: NaOH, 200 g/l + EDTA 10 g/l in wässriger Lösung. Der pH- Wert ist größer als 13. Anschließend wird die Kunststoffoberfläche in die 70° bis 80°C, vorzugsweise aber 70°C, warme Lösung für etwa 2 bis 10 Minuten, z.B. 5 Minuten, eingetaucht. Es erfolgt bei dieser Behandlung kein merklicher Abtrag an der Kunststoffoberfläche. Danach wird die Kunststoffoberfläche mit kaltem Wasser gespült. Die gespülte Oberfläche wird dann in einer Edelmetallkomplexsalzlösung behandelt, indem die Oberfläche in diese Lösung eingetaucht wird.

Vorzugsweise wird als Edelmetallkomplexsalzlösung eine salzsaure Lösung von Palladiumchlorid und Alkalichlorid verwendet, wobei diese Lösung anschließend mit Wasser verdünnt und danach der pH- Wert durch Zugabe von Alkalyhydroxidlösung auf etwa 5,5 eingestellt wird. Es kann Natriumchlorid in der bevorzugten Edelmetallkomplexsalzlösung verwendet werden. Die Konzentrationen sind folgende:

HCl: 10 ml/l

PdCl: 1 g/l

NaCl: 1 g/l.

Eine 1 N-NaOH-Lösung wird zugegeben bis der pH- Wert 5,5 ist.

Bei der Einstellung des pH- Werts auf etwa 5,5 findet durch Disproportionierung die Bildung von Edelmetallkomplexen statt. Nach dem Eintauchen der nach der oben dargelegten Methode vorbehandelten Kunststoffoberflächen in diese Lösung erfolgt ein Austausch des EDTA-Komplexes gegen den Edelmetallkomplex. Unter EDTA-Komplex sind hierbei die oben erwähnte Äthylendiamintetraessigsäure -Komplexe und/oder deren Salze zu verstehen.

5

Verantwortlich für diese Reaktion ist die Oberflächenaffinität der verschiedenen Komplexe.

Von der Kunststoffoberfläche muß die anhaftende Flüssigkeitsschicht abgespült werden. Dies geschieht vorteilhafterweise in einer alkalischen Lösung, welche das Auswaschen der Edelmetallkomplexe aus den von der Glaskugelbestrahlung erzeugten Kavernen verhindert, da die Edelmetallkomplexe in das Edelmetallhydroxid überführt werden, das voluminös ausflockt. Auf diese Weise wird das Edelmetall-Hydroxid in den Kavernen festgehalten. Die alkalische Lösung kann 1N-NaOH in wässriger Lösung sein.

Vorzugsweise erfolgt der Verfahrensschritt 1.4) durch eine chemische oder photochemische Reaktion.

Die chemische Reduktion des Edelmetallhydroxids findet vorteilhafterweise in einer alkalischen Formaldehydlösung oder in einer leicht sauren $SnCl_2$-Lösung statt. Wenn chemisch reduziert wird, ergeben sich Edelmetallkeime, die in die gesamte Oberfläche eingelagert sind. Auf diese Weise kann man Telefongehäuse oder auch Modeschmuck metallisieren. Die chemische Umwandlung des Edelmetallhydroxids kann in einer Formaldehydlösung von 600 ml/l mit einer Ausgangskonzentration von 25% oder einer Zinnchloridlösung von 1 g/l durchgeführt werden. Die Reduktionszeit ist 1 bis 10 Minuten bei Raumtemperatur. Die Lösungen werden durch Eintauchen zur Einwirkung gebracht. Will man photochemisch reduzieren, trägt man zweckmäßigerweise eine Suspension eines stark n-dotierten Halbleitermaterials durch Eintauchen auf die Oberfläche auf. Eine wässrige Lösung von n-dotiertem Germanium mit einer Korngröße von 1 $\mu$ kann für diesen Zweck benutzt werden. Die feinen Halbleiterkristallite sind Elektronenspender bei der Belichtung. Diese erfolgt über eine Filmmaske, wobei in diesem Falle das selektive Maximum der Empfindlichkeit bei der Wellenlänge von 0,9 $\mu$m liegt. Die frei werdenden Elektronen reduzieren das Edelmetallhydroxid zu Metallkeimen. Diese Methode gestattet eine selektive Bekeimung. Sie Suspension wird vorteilhafterweise in einer Ammoniumazetatlösung abgespült und das nicht belichtete, nicht reduzierte Edelmetallhydroxid in ein Edelmetallchlorid übergeführt und ausgewaschen, z.B. in fließendem Wasser. Die Ammoniumazetatlösung enthält 1 g/l Ammoniumazetat und wirkt auf die Kunststoffoberfläche bei Raumtemperatur für 1 bis 10 Minuten ein. Dabei erhält man nur an den belichteten Stellen der Oberfläche eine Edelmetallbekeimung. Danach erfolgt die chemische Metallisierung an denjenigen Stellen, an denen sich die Keime befinden.

Als Edelmetalle können Gold, Iridium, Osmium, Palladium, Platin, Rhodium, Ruthenium oder Silber benutzt werden. Vorzugsweise wird aber mit Palladium gearbeitet, da Palladium eine starke katalytische Wirkung besitzt, durch die die Abscheidungsgeschwindigkeit bei der chemischen Metallisierung erhöht wird. Bei reduktiv arbeitenden chemischen Metallisierungsbädern ist ein Katalysator wie Palladium vorteilhaft. Bei autokatalytisch arbeitenden Metallisierungsbädern können alle Edelmetalle verwendet werden. Man benutzt zweckmäßigerweise Edelmetallsalzlösungen, die mit einer Konzentration von ca. 1 Gramm pro Liter Wasser angesetzt sind.

Als abzuscheidende Metalle werden bevorzugt Kupfer, Nickel, Gold und Silber verwendet.

Um eine ausreichende Schichtstärke der Metallbelegung von 1 bis 3 $\mu$m zu erreichen, wird man bei der chemischen Metallabscheidung mit autokatalytischen Bädern arbeiten oder ein reduktiv arbeitendes Bad mit einer galvanisch arbeitenden Metallisierung kombinieren. Bei der galvanischen Nachverstärkung der Schicht ist eine Flächenbekeimung erforderlich, um die Stromführung zu gewährleisten.

Gegenüber der Vakuumaufdampfung von Metallen auf Kunststoffoberflächen hat das oben erläuterte Verfahren den Vorteil, daß es mit einem wesentlich kleineren apparativen Aufwand durchführbar ist.

Es können durch das vorstehend erläuterte Verfahren ABS- Kunststoffe metallisiert werden. Es ist auch möglich Duro- und Thermoplaste zu metallisieren. Metallisiert werden beispielsweise Leiterplatten, Telefongehäuse usw.

In der Lösung des Edelmetallkomplexsalzes bilden sich im Laufe der Zeit durch Disproportionierung Edelmetallkomplexe z.B. Tetrachlorkomplexe und Hexachlorkomplexe. Die Entstehung der Edelmetallkomplexe wird bei höheren Temperaturen begünstigt. Durch die Disproportionierung können nach dem Auftreten mehrerer Edelmetallkomplexzwischenstufen relativ stabile Komplexe wie z.B. Hexachlorkomplexe entstehen, die nur schwer reduzierbar sind.

Mit einer bevorzugten Weiterbildung des oben beschriebenen Verfahrens läßt sich erreichen, daß die durch Disproportionierung gebildeten für eine Reduzierung besonders geeigneten Edelmetallkomplexe für eine längere Zeitdauer auch bei Raumtemperatur stabilisiert werden.

8

Hierfür ist vorgesehen, daß der Lösung des Edelmetallkomplexsalzes, das vorzugsweise ein Palladiumkomplexsalz ist, Azeton hinzugefügt wird. Durch Azeton läßt
sich eine monatelange Stabilisierung der Edelmetallkomplexe erreichen. Häufige Umsetzungen der nach kurzer
Zeit auftretenden und für die Reduzierung nicht geeigneten Endstufen der Edelmetallkomplexe in das Ausgangsmaterial sind nicht notwendig. Bei einer zweckmäßigen
Ausgestaltung beträgt der Anteil des Azetons an der
Lösung des Edelmetallkomplexsalzes bis zu fünfzig Volumenprozent.

Bei einer günstigen Ausgestaltung ist vorgesehen, daß
die Edelmetallkomplexsalzlösung aus einer Lösung von
Palladiumchlorid und Alkalichlorid in Salzsäure besteht,
die mit Wasser verdünnt und durch Zugabe von Alkalihydroxidlösung auf einen pH- Wert von 5,5 eingestellt
wird, und daß das Azeton nach der Disproportionierung
des Palladiumchlorids zu einem Palladiumtetrachlorkomplex zugegeben wird. Mit dieser Maßnahme wird der
Palladiumtetrachlorkomplex für eine lange Zeit derart
stabilisiert, daß sich kein nennenswerter Anteil an
Palladiumhexachlorkomplexen bilden kann. Es hat sich
gezeigt, daß Palladiumtetrachlorkomplexe ohne diese
Zugabe von Azeton bei Raumtemperatur nur für 1 bis 2
Wochen beständig sind. Durch die vorstehend erläuterte
Maßnahme bleiben die Palladiumtetrachlorkomplexe über
Monate hinweg beständig.

Im folgenden ist ein Beispiel für Stabilisierung der
Edelmetallkomplexsalze angegeben.

9

## Beispiel

Eine Lösung aus Palladiumchlorid und Alkalichlorid wird salzsauer gelöst und anschließend mit Wasser verdünnt. Danach wird durch die Zugabe von Alkalihydroxidlösung ein pH- Wert von etwa 5,5 eingestellt. Nach der Einstellung auf diesen pH- Wert findet durch Disproportionierung eine Bildung von Edelmetallkomplexen statt. Es entsteht zunächst ein Palladiumtetrachlorkomplex $(P_d CL_4)^{--}$. Die salzsauere Lösung des Palladiumchlorids hat eine hell rotbraune Färbung. Mit der Zugabe von Alkalihydroxidlösung entstehen Flocken. Die rotbraune Lösung und diese Flocken reagieren durch Disproportionierung zu einer dunkelbraunen, klaren Lösung.

Das Zustandekommen des Palladiumtetrachloridkomplexes ist daher an der dunkelbraunen Farbe der klaren Lösung zu erkennen. Diese dunkelbraune Lösung tritt bei Raumtemperatur innerhalb von etwa 3 bis 4 Stunden auf. Bei Erwärmung auf ca. $70^{o}$C entstehen die an der dunkelbraunen Färbung der Lösung feststellbaren Palladiumtetrachlorkomplexe bereits in 30 bis 40 Minuten. Die Palladiumtetrachlorkomplexe, die sich für die nachfolgende chemische oder photochemische Reduktion besonders gut eignen, sind nur für 1 bis 2 Wochen beständig und gehen durch weitere Disproportionierung in Palladiumhexachlorkomplexe über, die nur schwer reduzierbar sind.

In die dunkelbraune, klare Lösung des Palladiumtetrachloridkomplexes wird zur Stabilisierung Azeton gegeben, dessen Anteil an der Lösung vorzugsweise ein Volumenprozent ausmacht. Auf diese Weise werden die Palladiumtetrachlorkomplexe für einen langen Zeitraum stabilisiert. Es hat sich gezeigt, daß dieser Zeitraum über 2 Monaten liegt.

Ohne diese Stabilisierung tritt bei der Durchführung des Verfahrens ein großer Bedarf an Palladiumkomplexsalzlösung auf, die bereits nach etwa 2 Wochen unbrauchbar wird. Es ist zwar möglich, die Hexakomplexsalzlösung wieder in das Ausgangsmaterial zurückzuverwandeln. Dies kann z.B. durch Herstellung einer stark alkalischen Lösung erfolgen, aus der das Palladium in Form von Hydroxid ausflockt und sedimentiert. Anschließend kann das Palladiumhydroxid bei Erwärmung in konzentrierter Salzsäure wieder in Palladiumchlorid umgewandelt werden. Diese zeitraubenden umständlichen und aufwendigen Verfahrensmaßnahmen werden durch die oben erläuterte Stabilisierung des Palladiumtetrachlorkomplexes zumindest für einen Zeitraum von über 2 Monaten vermieden. Es ist lediglich ein Ersatz des durch anhaftende Lösung an den Kunststoffoberflächen verschleppten Anteils notwendig, der aber sehr gering ist.

11

Patentansprüche:

1. Verfahren zur Aktivierung von Kunststoffoberflächen für eine chemische Bekeimung mit einem
Edelmetall, so daß danach eine Metallisierung
vorgenommen werden kann, gekennzeichnet durch
folgende Verfahrensschritte:

1.1 die Kunststoffoberfläche wird mechanisch
aufgerauht,

1.2 der Kunststoff wird in eine Lösung eines
Komplexbildners eingetaucht,

1.3 der Kunststoff wird anschließend in eine
Lösung eines Edelmetallkomplexsalzes eingetaucht, so daß an der Kunststoffoberfläche ein Austausch der im Verfahrensschritt 1.2 angelagerten Komplexe gegen
Edelmetallkomplexe erfolgt,

1.4 die Edelmetallkomplexe werden zu Metallkeimen reduziert.

2. Verfahren nach Anspruch 1,
dadurch gekennzeichnet,
daß die mechanische Aufrauhung nach dem Verfahrensschritt 1.1 mittels Glaskugelstrahlen
erfolgt, bei dem die Glaskugeln einen Durchmesser von etwa 120 bis 250 $\mu$m haben.

3. Verfahren nach Anspruch 1 oder 2, bei dem ein
glasfaserverstärkter Kunststoff verwendet wird,
dadurch gekennzeichnet, daß vor Ausführung des Verfahrensschrittes 1.2 der Kunststoff mit einem handelsüblichen Conditioner behandelt wird, um eine Benetzbarkeit der Glasfasern zu erreichen.

4. Verfahren nach Anspruch 1 oder einem der folgenden, dadurch gekennzeichnet, daß bei dem Verfahrensschritt 1.2 als Komplexbildner Äthylendiamintetraessigsäure oder deren Alkalimetallsalze verwendet werden.

5. Verfahren nach Anspruch 1 oder einem der folgenden, dadurch gekennzeichnet, daß als Edelmetallkomplexsalzlösung eine Lösung von Palladiumchlorid und Alkalichlorid in Salzsäure verwendet wird, wobei anschließend diese Lösung mit Wasser verdünnt und danach der pH- Wert durch Zugabe von Alkalihydroxidlösung auf etwa 5,5 eingestellt wird.

6. Verfahren nach Anspruch 1 oder einem der folgenden, dadurch gekennzeichnet, daß der Verfahrensschritt 1.4 durch eine chemische oder photochemische Reduktion erfolgt.

7. Verfahren nach Anspruch 1 oder einem der folgenden, dadurch gekennzeichnet,

daß der Lösung des Edelmetallkomplexsalzes, das vorzugsweise ein Palladiumkomplexsalz ist, Azeton hinzugefügt wird.

8. Verfahren nach Anspruch 7, dadurch gekennzeichnet, daß der Anteil des Azetons an der Lösung des Edelmetallkomplexsalzes bis zu fünfzig Volumenprozent beträgt.

9. Verfahren nach Anspruch 7 oder 8, dadurch gekennzeichnet, daß der Anteil des Azetons an der Lösung ein oder ungefähr ein Volumenprozent beträgt.

10. Verfahren nach Anspruch 7 oder einem der folgenden, dadurch gekennzeichnet, daß die Edelmetallkomplexsalzlösung aus einer Lösung von Palladiumchlorid und Alkalichlorid in Salzsäure besteht, die mit Wasser verdünnt und durch Zugabe von Alkalihydroxidlösung auf einen pH- Wert von 5,5 eingestellt wird, und daß das Azeton nach der Disproportionierung des Palladiumchlorids zu einem Palladiumtetrachlorkomplex zugegeben wird.

**Europäisches Patentamt**

## EUROPÄISCHER RECHERCHENBERICHT

Nummer der Anmeldung

EP 80101060.4

| | EINSCHLÄGIGE DOKUMENTE | | KLASSIFIKATION DER ANMELDUNG (Int Cl.³) |
|---|---|---|---|
| Kategorie | Kennzeichnung des Dokuments mit Angabe. soweit erforderlich, der maßgeblichen Teile | betrifft Anspruch | |
| | AT – B – 290 247 (DEGUSSA) <br> * Seiten 3-5; Ansprüche * <br> –– | 1,4,5 | C 23 C 17/00 <br> C 08 J 7/06 |
| | US – A – 3 962 496 (E.J.LEECH) <br> * Ansprüche * <br> –– | 1,4,5 | |
| | ELECTROCHEMICAL PUBLICATIONS LIMITED, 18 Colburn Avenue, Hatch End, Middlesex, England, 1968 <br> W. GOLDIE "Metallic coatings of plastics" volume 1, Seiten 22-25 und 41-44 <br> –––– | 1,5,7 | |

**RECHERCHIERTE SACHGEBIETE (Int. Cl.³)**

C 23 C

C 08 J

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

| X | Der vorliegende Recherchenbericht wurde für alle Patentansprüche erstellt. |
|---|---|

| Recherchenort | Abschlußdatum der Recherche | Prüfer |
|---|---|---|
| WIEN | 01-10-1980 | SLAMA |

EPA form 1503.1 06.78